# EUROPEAN PATENT APPLICATION

(11) **EP 4 624 939 A1**
(43) Date of publication of application: **01.10.2025**
(21) Application number: 25151725.6
(22) Date of filing: 14.01.2025
(51) Int. Cl.: G01R 1/20, G01R 1/30, G01R 19/00, H02M 1/00, H03F 3/45

(54) **DIFFERENTIAL CURRENT SENSOR**

(30) Priority: 25.03.2024 US 202418615969
(71) Applicant: Intel Corporation, Santa Clara, CA 95054 (US)
(72) Inventor: VEERABATHINI, Anurag, San Mateo, 94401 (US); HAIDER, Nazar, Fremont, 94539 (US)
(74) Representative: Viering, Jentschura & Partner mbB Patent- und Rechtsanwälte

(57) **Abstract**

Embodiments herein relate to a high-impedance current-sensing circuit. In one approach, the circuit includes first and second amplifiers which are coupled to first and second sense nodes, respectively, of a load to be monitored, one or more current mirrors to mirror a current to a voltage output node, and first and second resistors coupled to an input and output, respectively, of the one or more current mirrors. A voltage at the voltage output node is based on a current between the first and second sense nodes, and can be used for various purposes such as limiting the current through the load.

## Description

### BACKGROUND

Computing devices and other electronic systems often rely on current-sensing circuits to measure the current consumption of one or more circuits of the device. For example, a current-sensing circuit can measure a voltage drop across a sense resistor to measure a current input to the circuit. The measured current can be used for applications such as power management, processor workload monitoring, and battery monitoring.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
FIG. 1 depicts an example current-sensing circuit 100 comprising a difference amplifier 150, where the current-sensing circuit draws a current from first and second sense nodes S1 and S2, respectively, in accordance with various embodiments.
FIG. 2 depicts an example current-sensing circuit 200 comprising a difference amplifier 260 with input buffering via first and second amplifiers 220 and 240, respectively, in accordance with various embodiments.
FIG. 3 depicts an example current-sensing circuit 300 comprising an instrumentation amplifier, in accordance with various embodiments.
FIG. 4 depicts an example current-sensing circuit 400 comprising a current sense amplifier which draws a current from first and second sense nodes, in accordance with various embodiments.
FIG. 5 depicts example plots of di/dt versus frequency, in accordance with various embodiments.
FIG. 6 depicts an example high-impedance current-sensing circuit 600 comprising first and second buffering amplifiers 620 and 640, respectively, and first and second current mirrors 660 and 680, respectively, in accordance with various embodiments.
FIG. 7 depicts an example high-impedance current-sensing circuit 700 similar to the circuit 600 of FIG. 6 but having a divided sense input voltage, in accordance with various embodiments.
FIG. 8 depicts an example high-impedance current-sensing circuit 800 for voltage supply (Vdd)-referenced sensing, in accordance with various embodiments.
FIG. 9 depicts an example high-impedance current-sensing circuit 900 for ground voltage-referenced sensing, in accordance with various embodiments.
FIG. 10 depicts an example high-impedance current-sensing circuit 1000 similar to FIG. 6 but having a voltage-follower 1020 in place of the amplifier 620, in accordance with various embodiments.
FIG. 11 depicts an example high-impedance current-sensing circuit 1100 comprising a cascoding current mirror 1160 for better matching, in accordance with various embodiments.
FIG. 12 depicts an example high-impedance current-sensing circuit 1200 comprising source-follower amplifiers 1210 and 1220 and voltage supply-referenced sensing, in accordance with various embodiments.
FIG. 13 depicts an example high-impedance current-sensing circuit 1300 comprising source-follower amplifiers 1310 and 1320 and ground voltage-referenced sensing, in accordance with various embodiments.
FIG. 14 depicts an example high-level diagram of a high-impedance current-sensing circuit 1400, in accordance with various embodiments.
FIG. 15 depicts an example block diagram of a circuit 1500 in which a comparator 1510 uses an output voltage, Vout, from a high-impedance current-sensing circuit, in accordance with various embodiments.
FIG. 16 depicts an example block diagram of a circuit 1600 in which an analog-to-digital circuit (ADC) 1610 uses an output voltage, Vout, from a high-impedance current-sensing circuit, in accordance with various embodiments.
FIG. 17 depicts an example block diagram of a circuit 1700 in which a direct current (DC)-to-DC converter 1710 uses an output voltage, Vout, from a high-impedance current-sensing circuit, in accordance with various embodiments.
FIG. 18 depicts an example circuit 1800 which detects the current of processor cores and decides whether to throttle the processor cores, in accordance with various embodiments.
FIG. 19 depicts an example process for use with the circuit 1800 of FIG. 18, in accordance with various embodiments.
FIG. 20 depicts a circuit 2000 which provides an example implementation of the circuit 1800 of FIG. 18, in accordance with various embodiments.
FIG. 21 depicts example waveforms consistent with the current detector 2050 of FIG. 20, where a sensed current increases until it reaches a maximum allowed level, in accordance with various embodiments.
FIG. 22 depicts an example circuit 2200 which uses a high-impedance current-sensing circuit, in accordance with various embodiments.
FIG. 23 illustrates an example of components that may be present in a computing system 2350 for implementing the techniques (e.g., operations, processes, methods, and methodologies) described herein.

### DETAILED DESCRIPTION

As mentioned at the outset, current-sensing circuits are used in various applications. A current-sensing circuit can include amplifiers to provide precise current measurements in various electronic systems. However, these circuits typically have low input impedance and draw current from the sense nodes, increasing power consumption. Moreover, a sensed voltage at the sense nodes can be degraded when it reaches other circuits which rely on the voltage sense nodes. Another challenge is that there is a limited number of bumps, or solder balls, in a semiconductor package which are available for sensing.

The solutions provided herein address the above and other disadvantages. In one aspect, high-impedance current-sensing circuits are provided which substantially reduce a current draw and a quiescent current, while also minimizing circuit size.

In an example implementation, a current-sensing circuit or sense circuit includes first and second amplifiers which are coupled to first and second sense nodes, respectively, of a load to be monitored, one or more current mirrors to mirror a current to a voltage output node, and first and second resistors coupled to an input and output, respectively, of the one or more current mirrors. A voltage at the voltage output node is based on a current between the first and second sense nodes, and can be used for various purpose such as limiting the current through the load. The load can be a processor (including a processor core) or other circuit, for example.

In one approach, the amplifiers are difference amplifiers.

In one approach, the amplifiers are source-follower amplifiers.

In one approach, the sense nodes are at an intermediate point of a voltage divider.

In one approach, one or more other current-sensing circuits are coupled to the sense nodes.

The sense nodes can be coupled to a supply voltage side or a ground voltage side of the load.

The voltage output node can be referenced to a voltage supply or to ground.

The solutions provide a number of advantages. One advantage is detecting input current drawn by a processor or other circuit on multiple voltage domains. Another advantage is lowering the maximum current requirements of a Motherboard Voltage Regulator (MBVR) and Power Supply Unit (PSU). Another advantage is the ability to lower decoupling capacitances. Another advantage is enabling early virus workload detection by sensing input current drawn without affecting legitimate processor applications. Another advantage is the ability to support new future heavy workloads without the fear of power shutdown/failure. Another advantage is helping to solve multiple field/application issues.

These and other features will be further apparent in view of the following discussion.

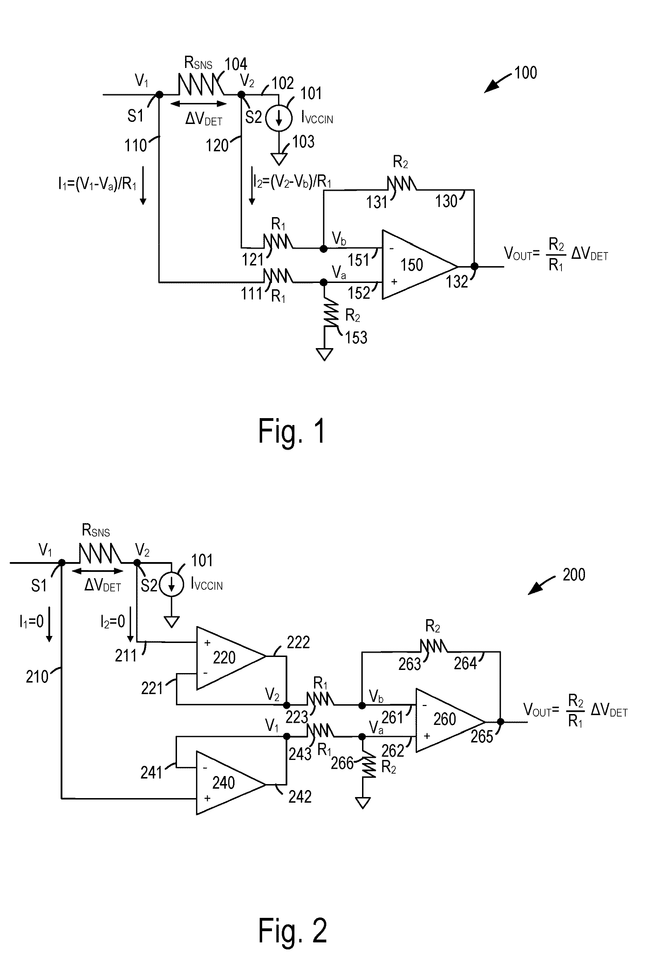

FIG. 1 depicts an example current-sensing circuit 100 comprising a difference amplifier 150, where the current-sensing circuit draws a current from first and second sense nodes S1 and S2, respectively, in accordance with various embodiments. A load 101 such as a processor or other circuit draws a current, Ivccin. The sense nodes are at a supply voltage side 102 of the load and a ground node 103 is at an opposite side of the load. A sense resistor 104 (Rsns) between the sense nodes will have a voltage drop of ΔVdet=V1-V2. The difference amplifier includes a non-inverting input 152 coupled to S1 via a path 110 and a resistor 111 (R1), and to ground (represented by an inverted triangle) by a resistor 153 (R2). The difference amplifier includes an inverting input 151 coupled to S2 via a path 120 and a resistor 121 (R1). The difference amplifier receives voltages Va and Vb at its non-inverting and inverting inputs, respectively. The output 132 of the amplifier 150 is fed back by a feedback path 130 and resistor 131 (R2) to the inverting input 151.

Vout is based on the voltage drop, ΔVdet. In this example, Vout=R2/R1 x ΔVdet. The difference amplifier 150 amplifies the difference between the two input signals V1 and V2 while rejecting any common-mode signals using a single amplifier. However, due to a relatively small input impedance, a current I1=(V1-Va)/R1 flows on the path 110 and a current I2=(V2-Vb)/R1 flows on the path 120, increasing power consumption.

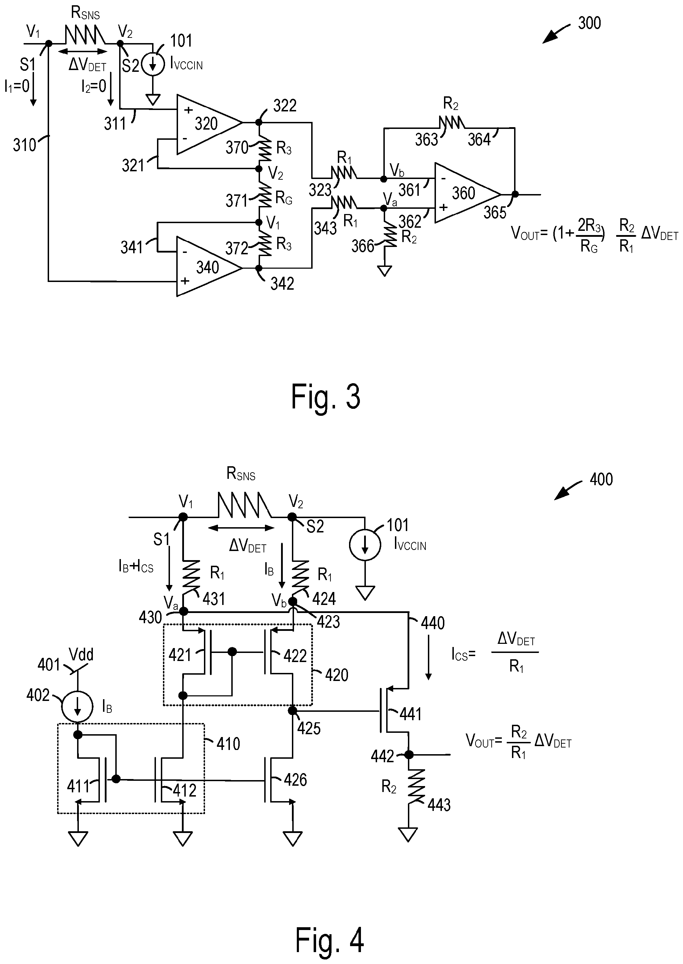

The circuits of FIGs. 2 and 3 can address the problem of a current draw with the use of a difference amplifier and two input buffering amplifiers that increase the input impedance. However, the use of three amplifiers increases the size of the circuit.

FIG. 2 depicts an example current-sensing circuit 200 comprising a difference amplifier 260 with input buffering via first and second amplifiers 220 and 240, respectively, in accordance with various embodiments. The sense nodes are at a supply voltage side of the load and a ground node is at an opposite side of the load. The circuit includes a first buffering amplifier 220 with a non-inverting input 211, an inverting input 221 and an output 222, and a second buffering amplifier 240 with a non-inverting input 210, an inverting input 241 and an output 242. A difference amplifier 260 (a third amplifier) has an inverting input 261 at a voltage Vb, a non-inverting input 262 at a voltage Va and an output 265 at a voltage Vout. The output is fed back by a feedback path 264 and resistor 263 (R2) to the inverting input 261. The output 222 of the amplifier 220 at a voltage V2 is coupled to the inverting input 261 of the amplifier 260 by a resistor 223 (R1), and the output 242 of the amplifier 240 at a voltage V1 is coupled to the non-inverting input 262 of the amplifier 260 by a resistor 243 (R1). The non-inverting input 262 of the amplifier 260 is also coupled to ground by a resistor 266 (R2).

In this example circuit, Vout=R2/R1 x ΔVdet. Advantageously, the presence of the buffer amplifiers results in a zero or negligible current I1=0 and I2=0 on non-inverting inputs 210 and 211, respectively. However, three amplifiers are used, resulting in a space and power penalty.

FIG. 3 depicts an example current-sensing circuit 300 comprising an instrumentation amplifier, in accordance with various embodiments. This circuit adds the capability of a programmable gain. The instrumentation amplifier comprises amplifiers 320, 340 and 360 and differs from the current-sensing circuit 200 by the addition of series resistors 370 (R3), 371 (Rg) and 372 (R3) between the outputs 322 and 342 of first and second buffering amplifiers 320 and 340, respectively. The resistor Rg can be programmable to provide a programmable gain for the circuit.

The sense nodes are at a supply voltage side of the load and a ground node is at an opposite side of the load. The circuit includes the first buffering amplifier 320 with a non-inverting input 311, an inverting input 321 and the output 322, and the second buffering amplifier 340 with a non-inverting input 310, an inverting input 341 and the output 342. A difference amplifier 360 (a third amplifier) has an inverting input 361 at a voltage Vb, a non-inverting input 362 at a voltage Va and an output 365 at a voltage Vout. The output is fed back by a feedback path 364 and resistor 363 (R2) to the inverting input 361.

In the series of resistors, the resistor 370 is between the output 322 and the inverting input 321, the resistor 371 is between the inverting inputs 321 and 341, and the resistor 372 is between the inverting input 341 and the output 342. V1 and V2 are voltages at the inverting inputs 341 and 321, respectively.

Additionally, the output 322 is coupled to the inverting input 361 by a resistor 323 (R1), and the output 342 is coupled to the non-inverting input 362 by a resistor 343 (R1). The non-inverting input 362 is also coupled to ground by a resistor 366 (R2).

In this example circuit, Vout=(1+2xR3/Rg) x R2/R1 x ΔVdet. Advantageously, the presence of the buffer amplifiers 320 and 340 results in a zero or negligible current I1=0 and I2=0 on paths. 310 and 311, respectively. However, as before, three amplifiers are used, resulting in a space and power penalty.

FIG. 4 depicts an example current-sensing circuit 400 comprising a current sense amplifier which draws a current from first and second sense nodes, in accordance with various embodiments. The sense nodes are at a supply voltage side of the load 101 and a ground node is at an opposite side of the load. In this circuit, a sensed voltage is converted into current. However, a current draw increases power consumption. This amplifier draws the bias current, IB, and the sensed current, ICS, from the sensed source. However, IB changes with process, voltage, temperature and aging, resulting in inaccuracies.

A current source 402 coupled to a power supply node 401 at Vdd provides a current Ib to a current mirror sink 410 comprising n-type transistors 411 and 412. For example, the transistors in this and other figures herein may be metal-oxide-semiconductor field-effect transistors (MOSFETs). The output of the current mirror is provided to a current mirror source 420 comprising p-type transistors 421 and 422. An n-type or p-type transistor is represented by a transistor symbol with an arrow pointing away from or toward, respectively, the control gate. A current mirror sink or source as described herein can be similar to the current mirror sink 410 or current mirror source 420, respectively.

As a result, Ib is provided at the node 423 which is coupled to S2 by a resistor 424 (R1). Additionally, a node 430 is coupled to S1 by a resistor 431 (R1), which carries a current Ib+Ics, where Ics is a sensed current. The p-type transistors 421 and 422 are connected as a current mirror conducts same current of Ib. The transistor 441 is coupled at its gate to a node 425, which in turn is coupled to ground by an n-type transistor 426. To regulate both source terminals 430 and 423 of the current mirror source 420, the node 425 adjusts the gate of the transistor 441 such that a difference current of Ics=ΔVdet/R1 is provided on path 440, which is an output of the current mirror source 420, to a p-type transistor 441, a voltage output node 442 and a grounded resistor 443 (R2). The transistors 411, 412 and 426 have their control gates coupled to one another. The voltage output node has a voltage Vout=R2/R1 x =ΔVdet.

The current mirrors 410 and 420 are first and second current mirrors, respectively.

FIGs. 1-4 demonstrate that in a system where the sense voltage is divided (e.g., by a resistor divider to scale down V1 and V2 to V1/2 and V2/2, respectively, the circuits of FIGs. 1 and 4 cannot be used because of the current draw of the sense nodes. The solution of FIG. 2 and 4 allow voltage division using a difference amplifier and two additional amplifiers as voltage buffers. However, the use of additional components including resistors and amplifiers consumes area and increases quiescent current, thus consuming more power.

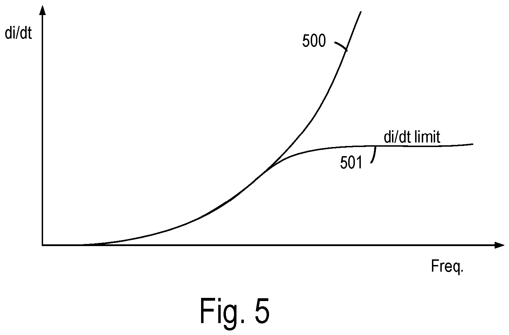

FIG. 5 depicts example plots of di/dt versus frequency, in accordance with various embodiments. The plot 500 represents the case where di/dt is not limited and the plot 501 represents the case where di/dt is limited. The frequency can be the operating frequency of a processor, for example. The solutions provided herein can sense the current and compare it to a reference threshold to decide whether the current has exceed a limit. The sensing and decision process can be done with a fast response time compared to techniques such as monitoring the output voltage of a voltage regulator.

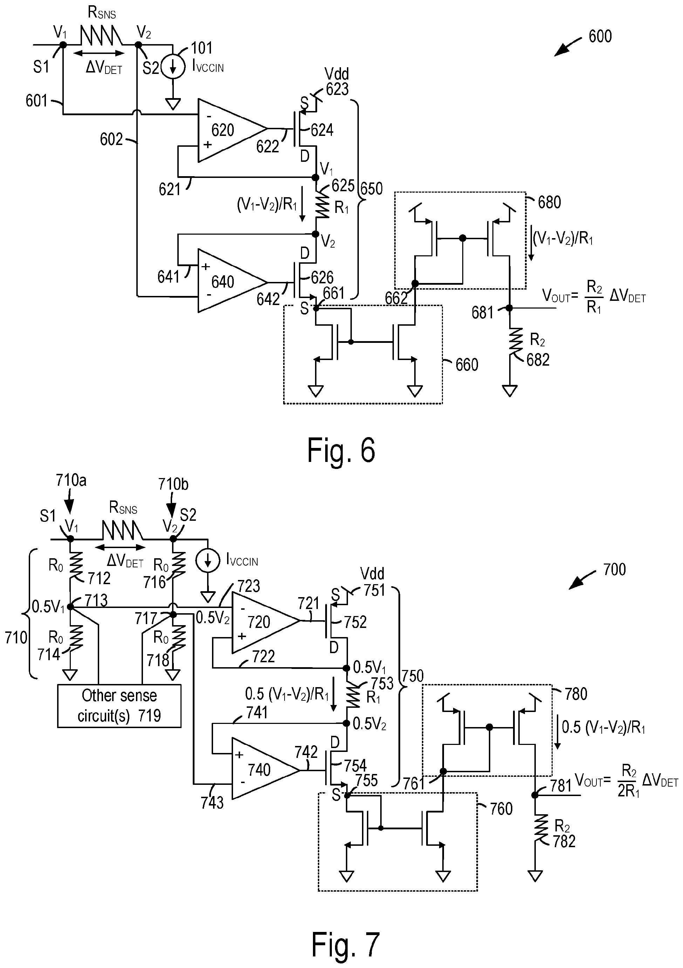

FIG. 6 depicts an example high-impedance current-sensing circuit 600 comprising first and second buffering amplifiers 620 and 640, respectively, and first and second current mirrors 660 and 680, respectively, in accordance with various embodiments. The sense nodes are at a supply voltage side of the load 101 and a ground node is at an opposite side of the load.

A goal of the circuit is to obtain a difference voltage with gain programmability using two amplifiers instead of the three amplifiers that are used in the instrumentation amplifier of FIG. 2. The proposed solution can optionally be used in a system where the sensed input voltage is divided down using a resistor divider such as depicted in FIG. 7.

A first buffering amplifier 620 has an inverting input 601 coupled to S1 at a voltage V1, a non-inverting input 621, and an output 622. A second buffering amplifier 640 has an inverting input 602 coupled to S2, a non-inverting input 641, and an output 642. The outputs 622 and 642 of the buffering amplifiers are coupled to gates of p-type and n-type transistors 624 and 626, respectively, in a current path 650. The source S of the transistor 624 is coupled to a power supply node 623 at a supply voltage Vdd and the drain D of the transistor 624 is coupled to the non-inverting input 621 at the voltage V1. A source S of the transistor 626 is coupled an input 661 of the current mirror sink 660, and the drain D of the transistor 626 is at a voltage V2 and is coupled to the inverting input 641.

The terms "S" and D" are used to denote the source or drain, respectively, of a transistor in the various figures. Also, consistent with the power supply node 623, a slanted line in the different figures represents a power supply node.

The current path also include a resistor 625 (R1) between the transistors 624 and 626, and coupled to the inverting inputs 621 and 641. A current of (V1-V2)/R1 flows in the current path with the inverting inputs 621 and 641 at voltages V1 and V2, respectively.

An output 662 of the current mirror sink 660 is an input to a current mirror source 680. An output 681 of the current mirror source 680 is a voltage output node which has a voltage Vout=R2/R1 x ΔVdet and is coupled to ground by a resistor 682 (R2).

The current mirrors have a 1:1 ratio in this example, so that the output current is equal to the input current. Alternatively, it is possible to have a different output-to-input current ratio. It is also possible for the ratio of a current mirror to be adjustable based on a set of transistors of different sizes at the input and/or output side, where one of the transistors can be select by a switch to set the output-to-input ratio. A transistor with a relatively large channel area, e.g., length or width, can be selected to pass a relatively large current.

The current mirrors 660 and 680 are first and second current mirrors, respectively.

In the circuit 600, the amplifiers 620 and 640 are voltage-to-current converters which are cascoded using a single resistor 625 (R1) to convert a sensed differential input voltage (ΔVdet) into a current (V1-V2)/R1. The amplifier 620 and the p-type transistor 624 force the drain of the transistor 624 to V1, and the amplifier 640 and the n-type transistor 626 force the drain of the transistor 626 to V2. Since R1 is connected between the drains of the transistors 624 and 626, a differential voltage of (V1-V2) is maintained across R1 to generate a current of (V1-V2)/R1. This current is mirrored into another matched resistor, R2 such that Vout= (R2/R1)*(V1-V2) or R2/R1 x (ΔVdet). R1 and/or R2 can be adjustable/programmable to adjust the gain of the circuit.

In an example implementation, the circuit 600 includes a first amplifier 620 coupled to a first sense node S1, a second amplifier 640 coupled to a second sense node S2, current mirrors 660 and 680 coupled to the first and second amplifiers, and a voltage output node 681 coupled to the current mirrors. A voltage of the voltage output node is based on a current between the first and second sense nodes, e.g., Vout=R2/R1 x (ΔVdet). The circuit also includes a current path 650 coupled to outputs 622 and 642 of the first and second amplifiers, respectively. The current mirrors comprise a first current mirror 660 having an input 661 coupled to the current path 650 and a second current mirror 680 to mirror an output current of the first current mirror to the voltage output node. Additionally, the current path can include a p-type transistor 624, a resistor 625, and an n-type transistor 626, where the p-type transistor comprises a source coupled to a power supply 623, a gate coupled to the output 622 of the first amplifier, and a drain coupled to a non-inverting input 621 of the first amplifier and to the resistor. Also, the n-type transistor comprises a drain coupled to the resistor and to a non-inverting input 641 of the second amplifier, a gate coupled to the output of the second amplifier, and a source coupled to the input 661 of the first current mirror.

In another example implementation, the circuit 600 includes a current path 650 comprising in series, a first transistor 624, a resistor 625, and a second transistor 626. The circuit also includes a first amplifier 620 having an inverting input 601 coupled to a first sense node S1 and a non-inverting input 621 coupled to the current path between the first transistor and the resistor, a second amplifier 640 having an inverting input 602 coupled to a second sense node S2 and a non-inverting input 641 coupled to the current path between the second transistor and the resistor. The circuit also includes current mirrors 660 and 680 coupled to the current path to copy a current of the current path to a voltage output node 681, where a voltage of the voltage output node is based on a voltage difference, ΔV, between the first and second sense nodes, e.g., Vout=R2/R1 x (ΔVdet).

FIG. 7 depicts an example high-impedance current-sensing circuit 700 similar to the circuit 600 of FIG. 6 but having a divided sense input voltage, in accordance with various embodiments. The voltages V1 and V2 at the sense nodes S1 and S2, respectively, are divided by first and second branches 710a and 710b, respectively, of a voltage divider 710. The reduced voltages allow the other components of the circuit to be reduced in size.

The first branch 710a includes a resistor 712 (R0), a first intermediate point 713, and a resistor 714 (R0). Since the resistors are equal in this example, V1 is divided in half to provide 0.5xV1 at the intermediate point 713. The second branch 710b includes a resistor 716 (R0), a second intermediate point 717, and a resistor 718 (R0). Since the resistors are equal in this example, V2 is divided in half to provide 0.5xV2 at the intermediate point 717. The intermediate points 713 and 717 can be coupled to one or more other sense circuits 719. This approach reduces the sense voltages from their original level, which may be too high for the amplifiers, transistors and other components, to a reduced, compatible level. The first and second intermediate points are also first and second sense nodes, respectively.

The resistors in each branch of the voltage divider can be unequal to provide a division ratio of other than 0.5. The voltage division can be obtained using transistors, diodes, and capacitors.

A first amplifier 720 has an inverting input 723 coupled to the first intermediate point 713, an output 721 coupled to the gate of a transistor 752, and a non-inverting input 722 coupled to a drain of the transistor 752 and to a resistor 753 (R1). A second amplifier 740 has an inverting input 743 coupled to the second intermediate point 717, an output 742 coupled to the gate of a transistor 754, and the non-inverting input 741 coupled to a drain of the transistor 754 and to the resistor 753 (R1).

A current path 750 includes a power supply node 751, the transistor 752, the resistor 753 and the transistor 754. The current path 750, and the source of the transistor 754, are coupled to an input 755 of a current mirror sink 760. The current path 750 has a current of 0.5×(V1-V2)/R1 in this example.

An output 761 of the current mirror sink 760 is an input of a current mirror source 780. An output of the current mirror source 780 is coupled to a voltage output node 781, which in turn is coupled to ground by a resistor 782 (R2). The voltage at the voltage output node 781 is Vout=R2/(2xR1) x ΔVdet.

The current mirrors 760 and 780 are first and second current mirrors, respectively.

Note that one or more other sense circuits 719 could also be coupled to S1 and S2 directly at voltages V1 and V2, respectively, such as in the circuits of FIGs. 6-10 and 12-14, if the one or more other sense circuits are rated to handle the higher voltage of V1 and V2.

The circuit provides an example where the difference voltage ΔVdet is sensed through a resistor divider, so that the gain is half that of the circuit of FIG. 6. Consider an example with V1=1.8V, Rsns= 0.5mΩ, IVccIN=200A, and R2=4xR1. This gives V2=1.7V for ΔVdet=100mV. Since a voltage divider is used, the amplifier 720 forces the drain of the transistor 752 to 0.9V and the amplifier 740 forces the drain of the transistor 754 to 0.85V to maintain 50mV across R1. A sensing current across Rsns at a relatively high supply voltage such as 1.8V with a voltage divider allows use of a 1V nominal supply for the analog blocks to leave enough headroom to copy the current across R1 using the current mirrors 760 and 780, to generate Vout=200mV.

Vout can be compared to a reference voltage using a comparator to create a current trigger. Note that the one or more other sense circuits can sense V1 or V2 on the same divider without any degradation.

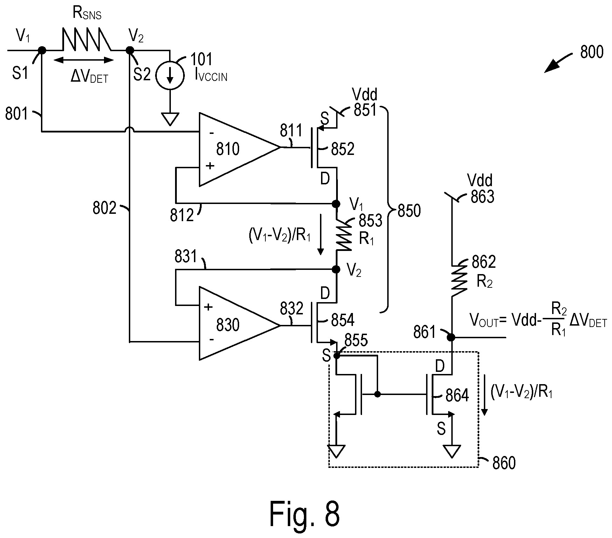

Another solution to realizing a voltage-to-current converter shown in FIG. 8 includes connecting a resistor R2 between the drain of a transistor 864 and a power supply node 863 to eliminate the additional current mirror 680 or 780 in FIG. 6 or 7, respectively.

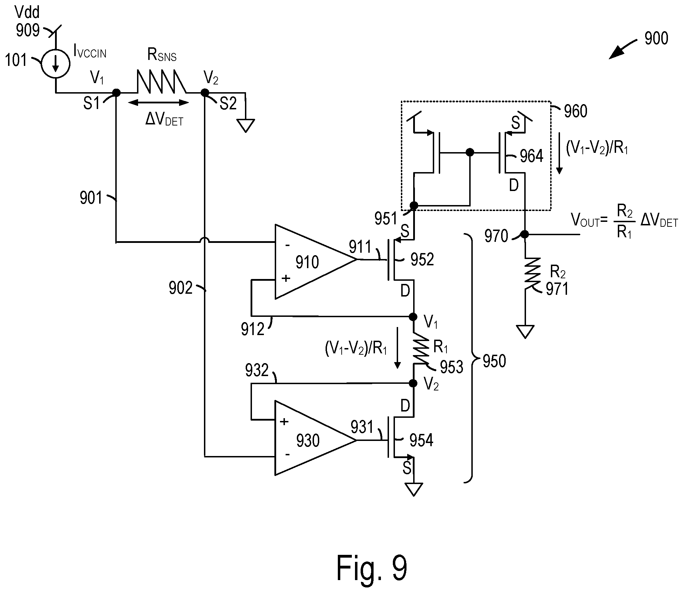

Another solution to realizing a voltage-to-current converter shown in FIG. 9 includes connecting a resistor R2 between the drain of a transistor 964 and a ground node 863 to eliminate the additional current mirror 680 or 780 in FIG. 6 or 7, respectively. This is an example of a low voltage (e.g., ground voltage) current sensing scheme.

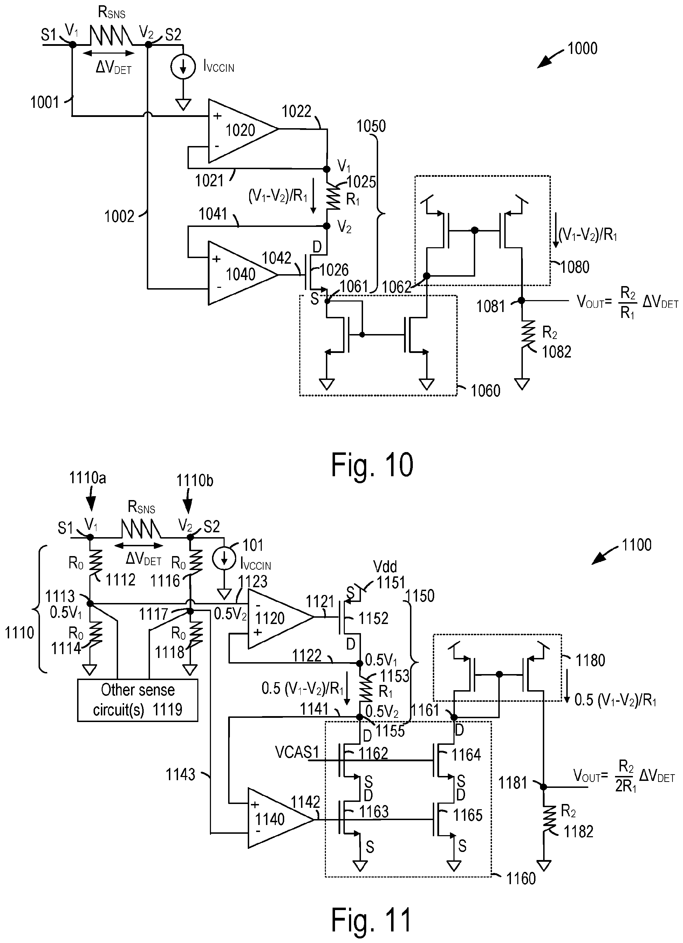

Another solution to realizing a voltage-to-current converter shown in FIG. 10 includes using a voltage-follower in place of an amplifier.

Another solution to realizing a voltage-to-current converter shown in FIG. 11 includes using cascoding transistors.

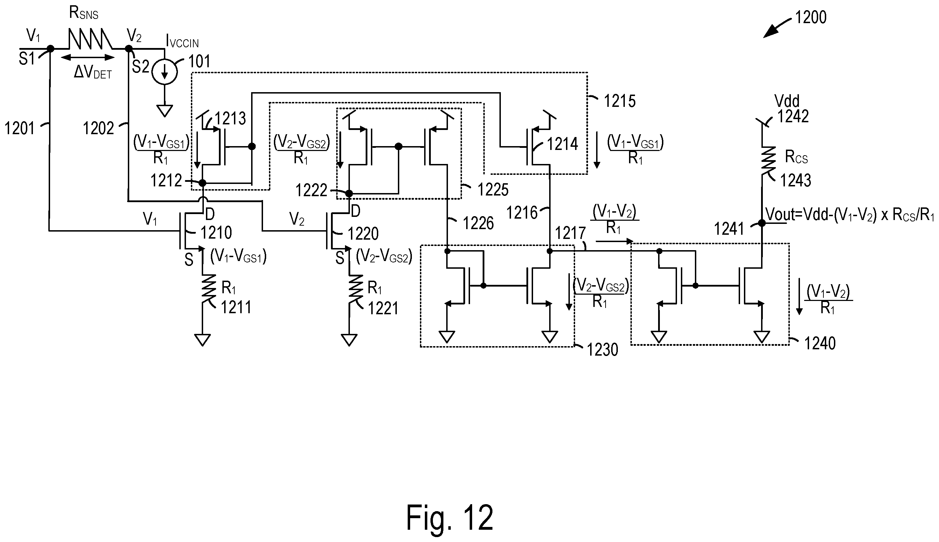

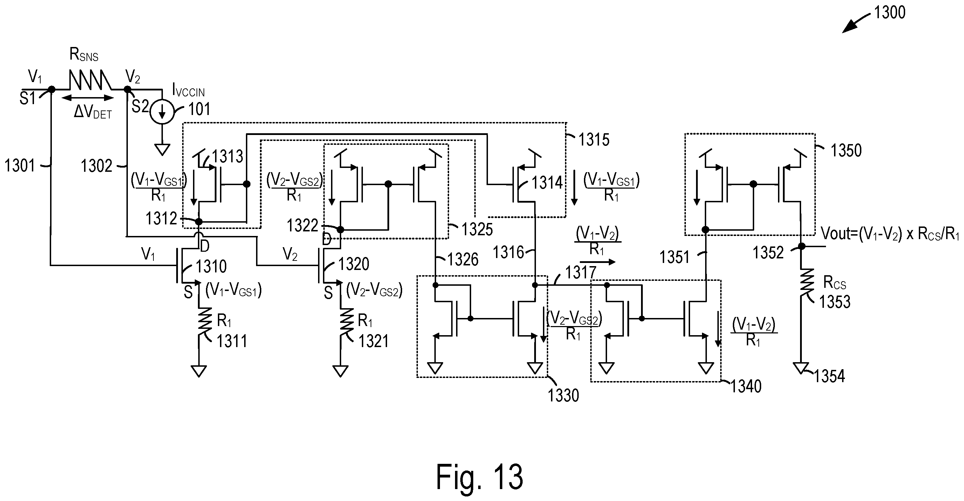

Another solution to realizing a voltage-to-current converter shown in FIGs. 12 and 13 includes using a source-follower that forces a differential voltage across R1.

FIG. 8 depicts an example high-impedance current-sensing circuit 800 for voltage supply (Vdd)-referenced sensing, in accordance with various embodiments. In this case, the output voltage Vout is based on the power supply voltage Vdd at a power supply node 863 and a voltage drop across the sense nodes S1 and S2. The circuit 800 includes a first amplifier 810 having an inverting input 801 coupled to S1, an output 811 coupled to the gate of a transistor 852, and a non-inverting input 812 coupled to a drain of the transistor 852 and to a resistor 853 (R1). A second amplifier 830 has an inverting input 802 coupled to S2, an output 832 coupled to the gate of a transistor 854, and a non-inverting input 831 coupled to a drain of the transistor 854 and to the resistor 853 (R1).

A current path 850 includes a power supply node 851, the transistor 852, the resistor 853 and the transistor 854. The current path, and the source of the transistor 854, are coupled to an input 855 of a current mirror sink 860. The path 850 has a current of (V1-V2)/R1.

An output of the current mirror sink 860 is a voltage output node 861 which is coupled to the power supply node 863 via a resistor 862 (R2). The voltage at the voltage output node is Vout=Vdd - R2/R1 x ΔVdet, and the current is (V1-V2)/R1.

The current mirror sink 860 includes a transistor 864 having a drain coupled to the voltage output node 861 and R2.

FIG. 9 depicts an example high-impedance current-sensing circuit 900 for ground voltage-referenced sensing, in accordance with various embodiments. In this case, the load 101 is upstream of the sense nodes S1 and S2, which in turn are coupled to ground. The load receives a voltage Vdd from a power supply node 909. The circuit 900 includes a first amplifier 910 having an inverting input 901 coupled to S1, an output 911 coupled to the gate of a transistor 952, and a non-inverting input 912 coupled to a drain of the transistor 952 and to a resistor 953 (R1). A second amplifier 930 has an inverting input 902 coupled to S2, an output 931 coupled to the gate of a transistor 954, and a non-inverting input 932 coupled to a drain of the transistor 954 and to the resistor 953 (R1).

A current path 950 includes the transistor 952, the resistor 953 and the transistor 954. The current path, and the source of the transistor 952, are coupled to an input 951 of a current mirror source 960. An output of the current mirror source 960 provides a current of (V1-V2)/R1 at a voltage output node 970, which is coupled to ground by a resistor 971 (R2). The voltage at the voltage output node is Vout=R2/R1 x ΔVdet. The current mirror source 960 includes a transistor 964 having a drain coupled to R2 and to the voltage output node 970.

FIG. 10 depicts an example high-impedance current-sensing circuit 1000 similar to FIG. 6 but having a voltage-follower 1020 in place of the amplifier 620, in accordance with various embodiments. The voltage-follower 1020, also referred to as a voltage buffer or a unity gain amplifier, is used in place of the first amplifier 620 of FIG. 6. The voltage-follower passes V1 from S1 to an output 1022.

The sense nodes are at a supply voltage side of the load 101 and a ground node is at an opposite side of the load.

The voltage-follower 1020 has a non-inverting input 1001 coupled to S1, an inverting input 1021, and an output 1022 coupled to the inverting input 1021. A second, buffering amplifier 1040 has an inverting input 1002 coupled to S2, a non-inverting input 1041, and an output 1042 which is coupled to the gate of the transistors 1026. A resistor 1025 (R1) is coupled at one end to the inverting input 1021 at a voltage V1 and at an opposite end to the non-inverting input 1041 at a voltage V2 and to a drain of the transistor 1026. A source of the transistor 1026 is coupled to an input 1061 of a current mirror sink 1060, which has an output 1062 coupled to the input of a current mirror source 1080. An output of the current mirror source 1080 at a voltage output node 1081 has a current (V1-V2)/R1. The voltage output node 1081 is coupled to ground by a resistor 1082 (R2) and has a voltage Vout=R2/R1 x ΔVdet.

The current mirrors 1060 and 1080 are first and second current mirrors, respectively.

A current path 1050 includes the resistor 1025 and the transistor 1026.

FIG. 11 depicts an example high-impedance current-sensing circuit 1100 comprising a cascoding current mirror 1160 for better matching, in accordance with various embodiments. The circuit 1100 is similar to the circuit 700 of FIG. 7 but has a cascode current mirror sink 1060 instead of the non-cascode current mirror sink 760. The cascode current mirror sink 1160 includes transistors 1162 and 1163 connected in series, and transistors 1164 and 1165 connected in series. These can be n-type transistors as shown, for example. The gates of the transistors 1162 and 1164 are coupled to one another and to a programmable voltage Vcas1. The gates of the transistors 1163 and 1165 are coupled to one another and to the output 1142 of the amplifier 1140. The cascoding current mirror has advantages such as reducing Vds (drain-to-source voltage) variations between the transistors 1163 and 1165 and providing a high output impedance to make the mirror current act more like an ideal current source. The cascoding current mirror thus provides more accurate copying of a current.

The voltages V1 and V2 at the sense nodes S1 and S2, respectively, are divided by first and second branches 1110a and 1110b, respectively, of a voltage divider 1110. The first branch 1110a includes a resistor 1112 (R0), a first intermediate point 1113, and a resistor 1114 (R0). Since the resistors are equal, V1 is divided in half to provide 0.5×V1 at the intermediate point 1113. The second branch 1110b includes a resistor 1116 (R0), a second intermediate point 1117, and a resistor 1118 (R0). Since the resistors are equal, V2 is divided in half to provide 0.5xV2 at the intermediate point 1117. The intermediate points 1113 and 1117 can be coupled to one or more other sense circuits 1119. The first and second intermediate points are also first and second sense nodes, respectively.

A first amplifier 1120 has an inverting input 1123 coupled to the first intermediate point 1113, an output 1121 coupled to the gate of a transistor 1152, and a non-inverting input 1122 coupled to a drain of the transistor 1152 and to a resistor 1153 (R1). A second amplifier 1140 has an inverting input 1143 coupled to the second intermediate point 1117, an output 1142 coupled to the gate of a transistor 1163, and the non-inverting input 1141 coupled to a drain of the transistor 1162 and to the resistor 1153 (R1).

A current path 1150 includes a power supply node 1151, the transistor 1152, and the resistor 1153. The current path, and the drain of the transistor 1162, are coupled to an input 1155 of the cascode current mirror sink 1160. The path has a current of 0.5×(V1-V2)/R1 in this example.

An output 1161 of the cascode current mirror sink 1160 is an input of a current mirror source 1180. An output of the current mirror source 1180 is coupled to a voltage output node 1181, which in turn is coupled to ground by a resistor 1182 (R2). The voltage at the voltage output node 1181 is Vout=R2/(2xR1) x ΔVdet.

The current mirrors 1160 and 1180 are first and second current mirrors, respectively.

FIG. 12 depicts an example high-impedance current-sensing circuit 1200 comprising source-follower amplifiers 1210 and 1220 and voltage supply-referenced sensing, in accordance with various embodiments. A source-follower amplifier, also referred to as a common-drain amplifier, can be implemented using an n-type transistor. The gate terminal of the transistor serves as the signal input, the source is the output, and the drain is common to both the input and output. A source-follower amplifier advantageously provides a high level of buffering and a high input impedance. The voltage gain is unity, although the current gain is relatively high.

In this example, a first source-follower amplifier comprises the transistor 1210 having a gate coupled to S1 by a path 1201, a drain coupled to a node 1212, and a source coupled to ground by a resistor 1211 (R1). Vgs1 is the gate-to-source voltage of the transistor 1210. The node 1212 is at the input of a current mirror source 1215 which includes transistors 1213 and 1214, and which has an input current of (V1-Vgs1)/R1. The voltage at the source of the transistor 1210 is V1-Vgs1.

Similarly, a second source-follower amplifier comprises the transistor 1220 having a gate coupled to S2 by a path 1202, a drain coupled to a node 1222, and a source coupled to ground by a resistor 1221 (R1). Vgs2 is the gate-to-source voltage of the transistor 1220. The node 1222 is at the input of a current mirror source 1225, which has an input current of (V2-Vgs2)/R1. The voltage at the source of the transistor 1220 is V2-Vgs2.

An output of the current mirror source 1225 at a node 1226 is provided as an input to a current mirror sink 1230.

An output current of the current mirror sink 1230, e.g., (V2-Vgs2)/R1, is subtracted from an output of the current mirror sink 1215, e.g., (V1-Vgs1)/R1, at an output node 1216 to provide a difference current, e.g., (V1-V2)/R1, on a path 1217. This current is provided to an input of a current mirror sink 1240. The current is mirrored to an output of the current mirror sink 1240 at a voltage output node 1241 which is coupled to a power supply node 1242 at Vdd by a current sense resistor 1243 (Rcs). The voltage at the voltage output node is Vout=Vdd-(V1-V2) x Rcs/R1.

The current mirrors 1215, 1225, 1230 and 1240 are first, second, third and fourth current mirrors, respectively.

In an example implementation, the circuit 1200 includes a first source-follower amplifier 1210 having a gate coupled to a first sense node S1, a second source-follower amplifier 1220 having a gate coupled to a second sense node S2, a first current mirror 1215 coupled to a drain 1212 of the first source-follower amplifier, a second current mirror 1225 coupled to a drain 1222 of the second source-follower amplifier, a third current mirror 1230 having an input 1226 coupled to an output of the second current mirror and an output 1216 coupled to an output of the first current mirror, and a fourth current mirror 1240 having an input 1217 coupled to an output of the third current mirror and an output coupled a voltage output node 1241. Additionally, a current at a path which is coupled to the output of the first current mirror and the output of the third current mirror is based on a difference between a current of the first current mirror and a current of the second current mirror.

FIG. 13 depicts an example high-impedance current-sensing circuit 1300 comprising source-follower amplifiers 1310 and 1320 and ground voltage-referenced sensing, in accordance with various embodiments. The voltage output node is referenced to, or coupled to, ground 1354 by a resistor 1353 (Rcs) rather than being coupled to a power supply node as in FIG. 12. An additional current mirror 1350 is also used.

In this example, a first source-follower amplifier comprises the transistor 1310 having a gate coupled to S1 by a path 1301, a drain coupled to a node 1312, and a source coupled to ground by a resistor 1311 (R1). Vgs1 is the gate-to-source voltage of the transistor 1310. The node 1312 is at the input of a current mirror source 1315 which includes transistors 1313 and 1314, and which has an input current of (V1-Vgs1)/R1. The voltage at the source of the transistor 1310 is V1-Vgs1.

Similarly, a second source-follower amplifier comprises the transistor 1320 having a gate coupled to S2 by a path 1302, a drain coupled to a node 1322, and a source coupled to ground by a resistor 1321 (R1). Vgs2 is the gate-to-source voltage of the transistor 1320. The node 1322 is at the input of a current mirror source 1325, which has an input current of (V2-Vgs2)/R1. The voltage at the source of the transistor 1320 is V2-Vgs2.

An output of the current mirror 1325 at a node 1326 is provided as an input to a current mirror sink 1330.

An output current of the current mirror sink 1330, e.g., (V2-Vgs2)/R1, is subtracted from an output of the current mirror 1315, e.g., (V1-Vgs1)/R1, at an output node 1316 to provide a difference current, e.g., (V1-V2)/R1, on a path 1317. This current is provided to an input of a current mirror sink 1340. The current is mirrored to an output of the current mirror sink 1340 at an input 1351 to a current mirror source 1350. An output of the current mirror source 1350 at a voltage output node 1352 is coupled to ground 1354 by a resistor 1353 (RCs). The voltage at the voltage output node is Vout=(V1-V2) x Rcs/R1.

The current mirrors 1315, 1325, 1330, 1340 and 1350 are first, second, third, fourth and fifth current mirrors, respectively.

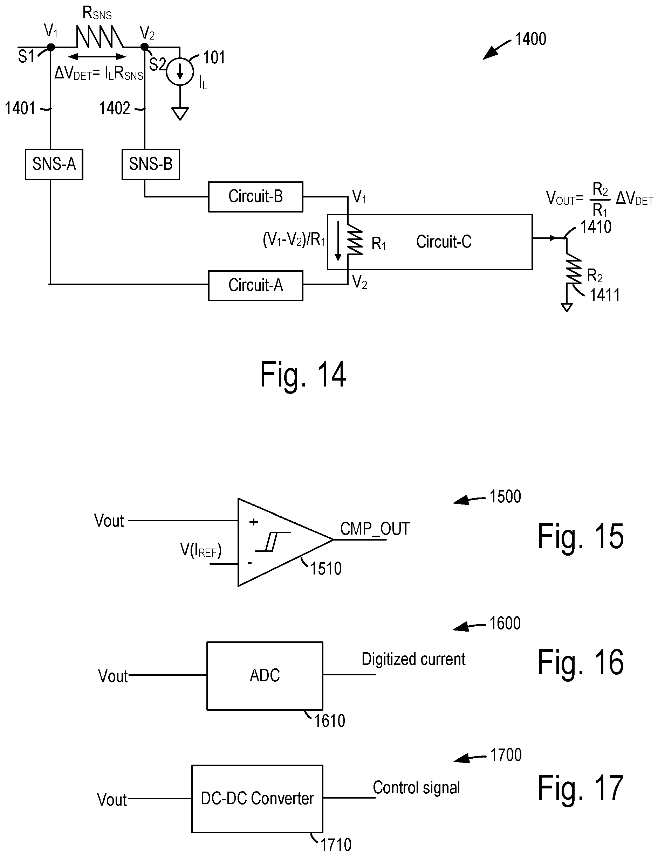

FIG. 14 depicts an example high-level diagram of a high-impedance current-sensing circuit 1400, in accordance with various embodiments. The voltages V1 and V2 at the sense nodes S1 and S2, respectively, are detected on paths 1401 and 1402, respectively, using sense blocks SNS-A and SNS-B. These sense blocks can include a voltage divider or a voltage follower that can be implemented using resistors, capacitors and/or transistors. In another approach, the sense blocks are pass-through wires. The sensed voltage is forced across a resistor R1 in a Circuit-C using Circuit-A and Circuit-B. These circuits can be implemented using transistors and amplifiers such that the current across R1 is (V1-V2)/R1. This constructed current across R1 is copied into another resistor R2 using Circuit-C such that the voltage across R2 is Vout= R2/R1(V1-V2). Vout is provided at a voltage sense node 1410 which is coupled to ground by the resistor 1411 (R2) in this example. Circuit-C can be implemented using amplifiers and transistors such as current mirror circuits in different configurations. The output voltage which represents the sensed current can be used in various applications such as depicted in FIGs. 15-17.

FIG. 15 depicts an example block diagram of a circuit 1500 in which a comparator 1510 uses an output voltage, Vout, from a high-impedance current-sensing circuit, in accordance with various embodiments. In this example, the comparator 1510 is used to detect the current based on the level of Vout relative to V(Iref), a voltage threshold or reference associated with a reference current. The comparator can output a signal CMP_OUT which indicates whether Vout is above or below the threshold, for example. CMP_OUT can be used by a downstream control circuit such as to make decisions regarding throttling a processor by reducing its operating frequency.

FIG. 16 depicts an example block diagram of a circuit 1600 in which an analog-to-digital circuit (ADC) 1610 uses an output voltage, Vout, from a high-impedance current-sensing circuit, in accordance with various embodiments. In this example, the ADC outputs a digitized current, e.g., a digital value representing the current based on Vout. For example, the digitized current can represent the current drawn by a load such as processor.

FIG. 17 depicts an example block diagram of a circuit 1700 in which a direct current (DC)-to-DC converter 1710 uses an output voltage, Vout, from a high-impedance current-sensing circuit, in accordance with various embodiments. In this example, the DC-DC converter outputs a control signal based on Vout. The control signal can be used by a downstream control circuit such as to make decisions regarding throttling a processor by reducing its operating frequency.

The sensed current can be used by DC-DC power converter circuits to limit the current in an inductor, power transistor and/or output load for current regulation.

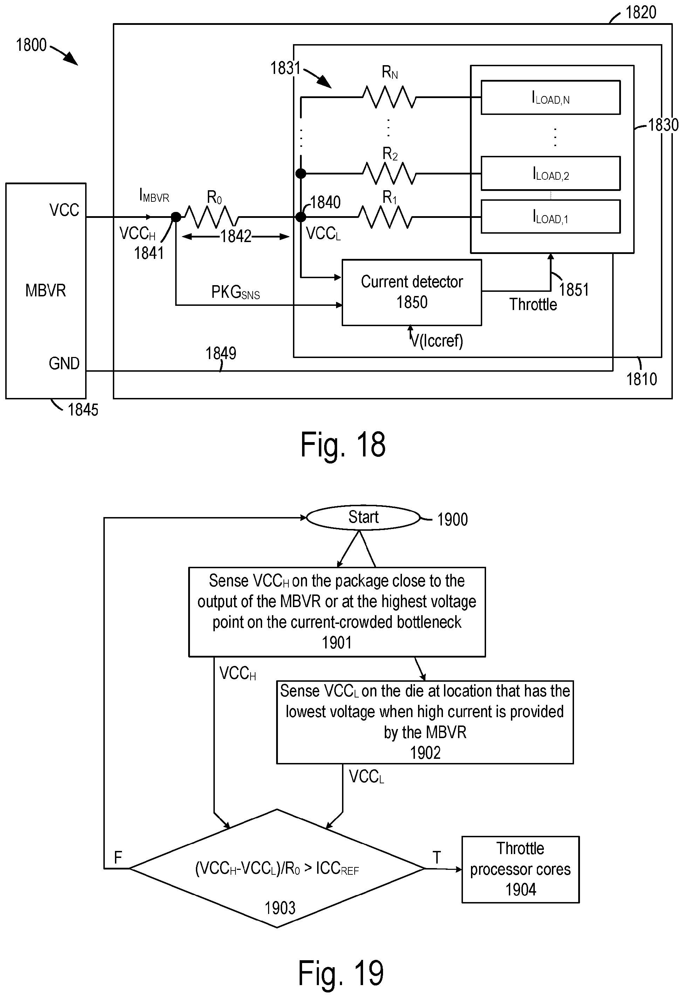

FIG. 18 depicts an example circuit 1800 which detects the current of processor cores and decides whether to throttle the processor cores, in accordance with various embodiments. The circuit includes a die 1810 in a package 1820. A motherboard voltage regulator (MBVR) 1845 may be external to the package and provide a voltage Vcc and a current Imbvr to a number N of loads 1830 in the die. The loads can be, e.g., processors, including processor cores, or other circuits, where each load draws a load current Iload, 1, Iload,2, ..., Iload,N via a respective metal path 1831 having an impedance represented by R1, R2, ..., RN, respectively. The MBVR voltage and current are provided to the respective metal paths via a first sense node 1841 (with voltage VccH) on the package and a second sense node 1840 (with voltage VccL) on the die. A metal path 1842 between the sense nodes has an impedance represented by R0, and represents a current-crowded bottleneck, e.g., a single path where current passes for all of the loads. The MBVR 1845 and the loads 1830 are also coupled to a ground path 1849.

A current detector 1850 can be any of the high-impedance current-sensing circuits described herein. The current sensor is coupled to the sense nodes 1841 and 1840 to detect the current Imbvr based on VccH-VccL and to compare it to a voltage corresponding to a reference current, V(Iccref). Based on the comparison, the current detector 1850 decides sets a throttling signal on a path 1851 to the load 1830 to an on or off state, for example. The current detector can be a control circuit which operates using hardware and/or software.

The sense nodes 1840 and 1841 can be bumps, e.g., solder balls, for example. The high-impedance current-sensing circuits described herein can advantageously use existing sense nodes while minimizing power consumption.

The circuit 1800 operates by detecting an input current by measuring the differential voltage drop across the sense nodes 1841 and 1840. The sense node 1841 of the package can be selected to be close to the MBVR or the high-side of the input current bottleneck (metal path 1842) on a printed circuit board (PCB). The sense node 1840 of the die can be selected such that a relatively large voltage drop is observed when there is a relatively high current workload. If the sensed voltage is higher than a reference voltage, the processor cores are throttled to limit a rise in the input current. Since the package parasitics are well-controlled compared to the board parasitics, the input current can be measured with fewer variations.

Specifically, the high side voltage, VccH, of the current bottleneck is sensed on the package and the lowest voltage point, VccL, is sensed on the die. If (VccH-VccL)/R0 is greater than a reference current, IccREF, then the processor cores are throttled. IccREF can be close to the application current, IccMax.App. IccMax.Max is the maximum current drawn by a load when working at 100% of its capacity. IccMax.App is less than IccMax.Max and is the current drawn by a processor while running typical user applications.

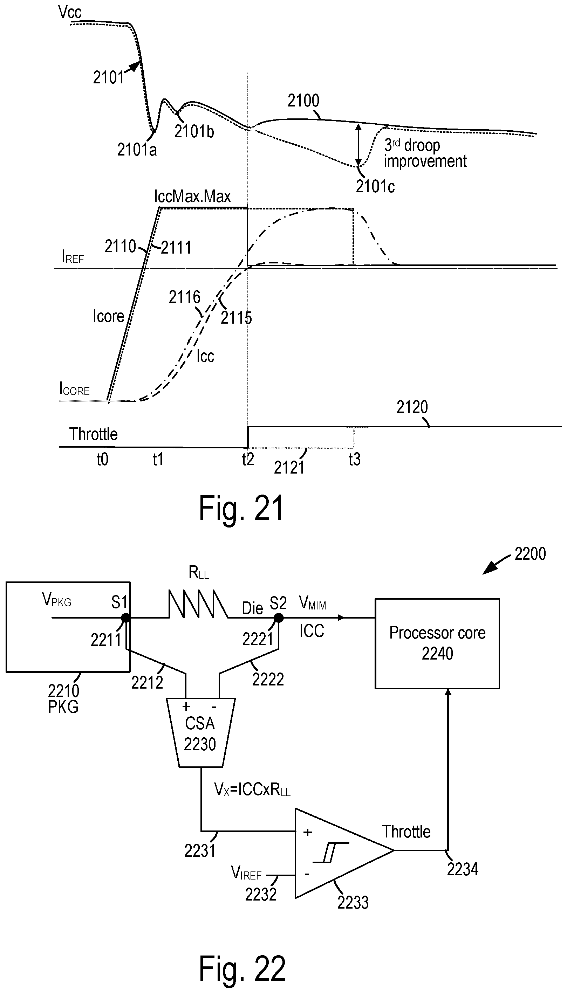

The circuit 1800 provides a number of benefits, including a reduced or limited maximum input current on the processor (IccMax.App + Sensor Error) which is less than IccMax.Max, a significant reduction in MBVR capacitance, an increased input voltage margin to a fully integrated voltage regulator (FIVR) by limiting the 3rd droop (FIG. 21), early detection without affecting other processor applications, the ability to support new future heavy workloads without the fear of power shutdown/failure, and solving multiple field/application issues.

FIG. 19 depicts an example process for use with the circuit 1800 of FIG. 18, in accordance with various embodiments. The process starts at an operation 1900. An operation 1901 includes sensing VccH on the package close to the output of the MBVR, e.g., at the sense node 1841, or at the highest voltage point on the current-crowded bottleneck 1842. An operation 1902 includes sensing VccL on the die at a location, e.g., at the sense node 1840, that has the lowest voltage when a relatively high current is provided by the MBVR. A decision operation 1903 receives the voltages VccH and VccL based on the operations 1901 and 1902, respectively, and determines whether (VccH-VccL)/R0 > IccREF. If the evaluation is true (T), operation 1904 is reached which can include throttling the processor cores. If the evaluation is false (F), operation 1900 is reached to start the process again in another iteration. Operation 1900 can also be reached from operation 1904. The process can be repeated periodically at defined intervals.

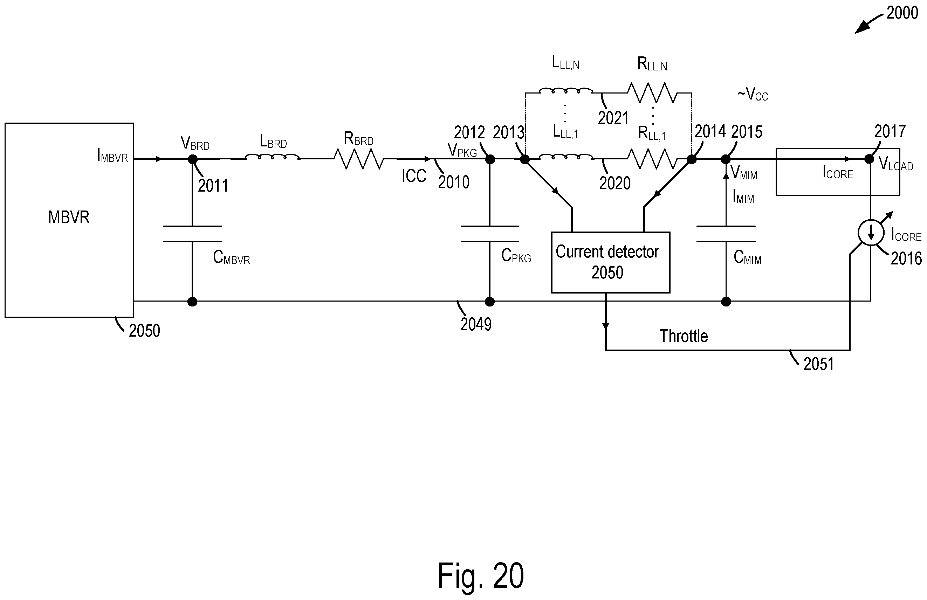

FIG. 20 depicts a circuit 2000 which provides an example implementation of the circuit 1800 of FIG. 18, in accordance with various embodiments. A first path 2010 is coupled to the voltage and current output of the MBVR 2050 and carries a current Icc, while a second path 2049 is coupled to ground. Cmbvr represents a capacitance of the MBVR between the node 2011 and ground. The first path also includes an inductance Lbrd and resistance Rbrd of the motherboard (BRD). Cpkg represents a package capacitance between the node 2012 and ground. A first sense node 2013 (a package sense node) and a second sense node 2014 (a die sense node) are coupled to the current detector 2050. A voltage drop between these nodes is indicative of the current Icc on the first path 2010. A set of a number N looad lines 2020, ..., 2021, including 1^{st} through Nth load lines, can be coupled between the sense nodes. Each load line can include an inductance L_{LL} and an impedance R_{LL} in series. CMIM represents an on-die capacitance between the node 2015 (at a voltage VMIM) and ground. MIM denotes metal-insulator-metal. A current Icore 2016 draws current from the set of load lines to an output node 2017 at a voltage Vload. Icore represents a current demand or consumption by processor cores or logic connected between the node 2017 and ground. Icore is adjustable based on a throttling signal on the path 2051 from the current detector.

In the circuit 2000, the input current into the processor, Icc, is detected by measuring the voltage drop across the bottleneck current path between the package pin (sense node 2013) and the on-die sense pin (sense node 2014). The core frequency is reduced by a throttling signal if the input current is greater than a predefined reference, IREF. When a large workload step is applied such that Icore reaches IccMax.Max, the on-die capacitance, CMIM, and the package capacitance, CPKG, support this current to limit the 1st and 2nd droops in FIG. 21. It can take about 1-2µs for the input current, Icc, to see and respond to the core current changes due to parasitics in the power delivery network. When Icc is greater than IREF, the cores are throttled to reduce the input current (see FIG. 21).

FIG. 21 depicts example waveforms consistent with the current detector 2050 of FIG. 20, where a sensed current increases until it reaches a maximum allowed level, in accordance with various embodiments. The plot 2100 depicts Vcc with the use of a high-impedance current-sensing circuit, and the plot 2101 depicts Vcc in a comparative example. The plot 2110 depicts Icore, a current of a processor core, with the use of a high-impedance current-sensing circuit, and the plot 2111 depicts Icore in a comparative example. The plot 2115 depicts Icc with the use of a high-impedance current-sensing circuit, and the plot 2116 depicts Icc in a comparative example. The plot 2120 depict a throttle signal with the use of a high-impedance current-sensing circuit, and the plot 2121 depicts a throttle signal in a comparative example.

A time line includes time points t0-t3. From t0-t1, Icore increases and Vcc decreases as the processor increases its workload. At t1, Icore reaches a maximum, IccMax.Max, and remains at that level (plots 2110 and 2111) until at least t2. For the comparative example, Icore (plot 2111) remains at IccMax.Max until t3, when the throttle signal (plot 2121) is asserted, causing, Icore to decrease to Iref. With the use of a high-impedance current-sensing circuit (plot 2110), Icore remains at IccMax.Max until t2, when the throttle signal (plot 2120) is asserted, causing, Icore to decrease to Iref. Also from t1-t2, Icc increases (plots 2115 and 2116). For the comparative example (plot 2116), Icc continues to increase above Iref after t2 until it reaches and stabilizes at IccMax.Max. Icc then decreases back to Iref when the throttle signal (plot 2121) is asserted at t3. For the high-impedance current-sensing circuit (plot 2115), Icc stabilizes at Iref at t2 and remains at that level.

Referring again to Vcc, in the comparative example (plot 2101), when the increase in Icore is suddenly halted at t1, this can cause first and second dips 2101a and 2101b, respectively, in Vcc. Additionally, in the comparative example, plot 2101c denotes a third dip which occurs when Icore transitions from IccMax.Max to Iref at t3. This third dip is avoided using the high-impedance current-sensing circuit (plot 2100), where Vcc remains stable from t2-t3.

Observe that ICC never reaches IccMax.Max plot (2115) and the cores running at IccMax.Max are supported by on-die and package capacitances. Limiting ICC greatly reduces MBVR power and decoupling capacitance requirements. An early throttling also improves the 3rd droop to increase the input minimum input voltage margin for an on-die voltage regulator.

FIG. 22 depicts an example circuit 2200 which uses a high-impedance current-sensing circuit, in accordance with various embodiments. The implementation depicts the package (PKG) 2210 and a first sense node 2211 (S1), at the package, which is coupled to a non-inverting input 2212 of a current sense amplifier (CSA) 2230. A second sense node 2221, at the die, is coupled to an inverting input 2222 of the CSA. The CSA can be any of the high-impedance current-sensing circuits described herein. The CSA outputs a voltage Vx=IccxRLL to a non-inverting input 2231 of a comparator 2233, while a reference voltage VIREF is provided on an inverting input 2232 of the comparator. Based on the two inputs, the comparator decides whether to set a throttling signal to an on state on a path 2234 for a processor core 2240. For example, the comparator can decide to set the throttling signal when Vx>VIREF. Note that multiple comparators can potentially be used to compare Vx to different thresholds to decide whether to set different levels of throttling.

In this implementation, the CSA measures the voltage drop across a selected load line impedance, RLL. The load current, Icc flows through RLL, to provide Vx=IccxRLL which in turn is compared to a reference, VIREF, to determine whether to throttle the cores. The package parasitics are well-controlled compared to board parasitics and the input current can be measured with fewer variations.

Additionally, an on-die temperature sensor (DTS) can be used to implement a temperature compensation technique as the sensed resistance can change with temperature.

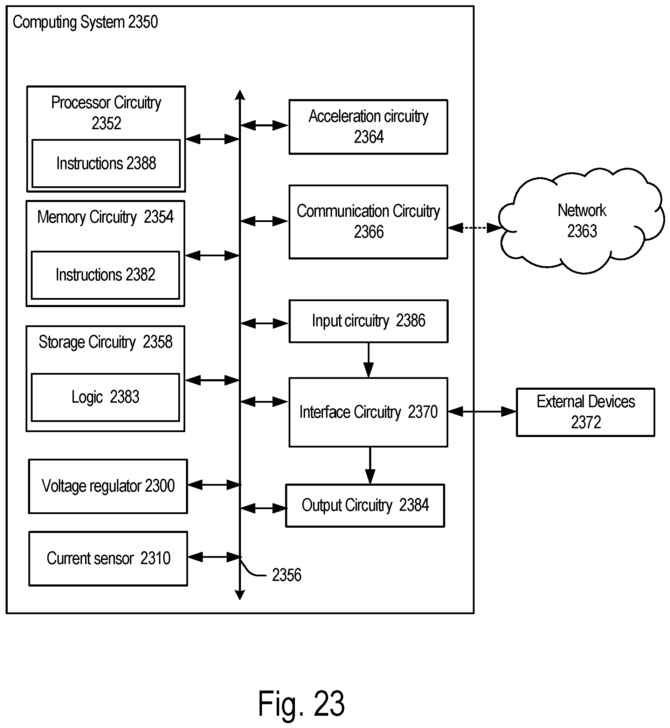

FIG. 23 illustrates an example of components that may be present in a computing system 2350 for implementing the techniques (e.g., operations, processes, methods, and methodologies) described herein. The current sensor 2310 may represent any of the high-impedance current-sensing circuit described herein. Additionally, the processor circuitry 2352 may represent one or more processors or cores which are throttles based on a throttle signal from the current sensor. The voltage regulator 2300 may represent the MBVR 1845 or 2050.

The computing system 2350 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 2350, or as components otherwise incorporated within a chassis of a larger system.

In one approach, all or part of the computing system 2350 is provided in a SoP, System in Package (SiP) or a System on Chip (SoC).

The voltage regulator can provide a voltage Vout to one or more of the components of the computing system 2350. The memory circuitry 2354 may store instructions and the processor circuitry 2352 may execute the instructions to perform the functions described herein.

The system 2350 includes processor circuitry in the form of one or more processors 2352. The processor circuitry 2352 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 2352 may include one or more hardware accelerators (e.g., same or similar to acceleration circuitry 2364), which may be microprocessors, programmable processing devices (e.g., FPGA, ASIC, etc.), or the like. The one or more accelerators may include, for example, computer vision and/or deep learning accelerators. In some implementations, the processor circuitry 2352 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 2352 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 2352 may be coupled with or may include memory/storage and may be configured to execute instructions stored in the memory/storage to enable various applications or operating systems to run on the platform 2350. The processors (or cores) 2352 is configured to operate application software to provide a specific service to a user of the platform 2350. In some embodiments, the processor(s) 2352 may be a special-purpose processor(s)/controller(s) configured (or configurable) to operate according to the various embodiments herein.

As examples, the processor(s) 2352 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 2352 may be a part of a system on a chip (SoC), System-in-Package (SiP), a multi-chip package (MCP), and/or the like, in which the processor(s) 2352 and other components are formed into a single integrated circuit, or a single package, such as the Edison^{™} or Galileo^{™} SoC boards from Intel^{®} Corporation. Other examples of the processor(s) 2352 are mentioned elsewhere in the present disclosure.

The system 2350 may include or be coupled to acceleration circuitry 2364, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 2364 may comprise logic blocks or logic fabric and other interconnected resources that may be programmed (configured) to perform various functions, such as the procedures, methods, functions, etc. of the various embodiments discussed herein. In such implementations, the acceleration circuitry 2364 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 2352 and/or acceleration circuitry 2364 may include hardware elements specifically tailored for machine learning and/or artificial intelligence (AI) functionality. In these implementations, the processor circuitry 2352 and/or acceleration circuitry 2364 may be, or may include, an AI engine chip that can run many different kinds of AI instruction sets once loaded with the appropriate weightings and training code. Additionally or alternatively, the processor circuitry 2352 and/or acceleration circuitry 2364 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google^{®} Inc., Real AI Processors (RAPs^{™}) provided by AlphaICs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 2352 and/or acceleration circuitry 2364 and/or hardware accelerator circuitry may be implemented as AI accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 or A12 Bionic SoC, the Neural Processing Unit (NPU) within the HiSilicon Kirin provided by Huawei^{®}, and/or the like. In some hardware-based implementations, individual subsystems of system 2350 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 2350 also includes system memory 2354. Any number of memory devices may be used to provide for a given amount of system memory. As examples, the memory 2354 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 2354 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 2354 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 2358 provides persistent storage of information such as data, applications, operating systems and so forth. In an example, the storage circuitry 2358 may be implemented via a solid-state disk drive (SSDD) and/or high-speed electrically erasable memory (commonly referred to as "flash memory"). Other devices that may be used for the storage circuitry 2358 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 2354 and/or storage circuitry 2358 may also incorporate three-dimensional (3D) cross-point (XPOINT) memories from Intel^{®} and Micron^{®}.

The memory circuitry 2354 and/or storage circuitry 2358 is/are configured to store computational logic 2383 in the form of software, firmware, microcode, or hardware-level instructions to implement the techniques described herein. The computational logic 2383 may be employed to store working copies and/or permanent copies of programming instructions, or data to create the programming instructions, for the operation of various components of system 2350 (e.g., drivers, libraries, application programming interfaces (APIs), etc.), an operating system of system 2350, one or more applications, and/or for carrying out the embodiments discussed herein. The computational logic 2383 may be stored or loaded into memory circuitry 2354 as instructions 2382, or data to create the instructions 2382, which are then accessed for execution by the processor circuitry 2352 to carry out the functions described herein. The processor circuitry 2352 and/or the acceleration circuitry 2364 accesses the memory circuitry 2354 and/or the storage circuitry 2358 over the interconnect (IX) 2356. The instructions 2382 direct the processor circuitry 2352 to perform a specific sequence or flow of actions, for example, as described with respect to flowchart(s) and block diagram(s) of operations and functionality depicted previously. The various elements may be implemented by assembler instructions supported by processor circuitry 2352 or high-level languages that may be compiled into instructions 2388, or data to create the instructions 2388, to be executed by the processor circuitry 2352. The permanent copy of the programming instructions may be placed into persistent storage devices of storage circuitry 2358 in the factory or in the field through, for example, a distribution medium (not shown), through a communication interface (e.g., from a distribution server (not shown)), over-the-air (OTA), or any combination thereof.

The IX 2356 couples the processor 2352 to communication circuitry 2366 for communications with other devices, such as a remote server (not shown) and the like. The communication circuitry 2366 is a hardware element, or collection of hardware elements, used to communicate over one or more networks 2363 and/or with other devices. In one example, communication circuitry 2366 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 2366 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 2356 also couples the processor 2352 to interface circuitry 2370 that is used to connect system 2350 with one or more external devices 2372. The external devices 2372 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 2350, which are referred to as input circuitry 2386 and output circuitry 2384. The input circuitry 2386 and output circuitry 2384 include one or more user interfaces designed to enable user interaction with the platform 2350 and/or peripheral component interfaces designed to enable peripheral component interaction with the platform 2350. Input circuitry 2386 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 2384 may be included to show information or otherwise convey information, such as sensor readings, actuator position(s), or other like information. Data and/or graphics may be displayed on one or more user interface components of the output circuitry 2384. Output circuitry 2384 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 2350. The output circuitry 2384 may also include speakers and/or other audio emitting devices, printer(s), and/or the like. Additionally or alternatively, sensor(s) may be used as the input circuitry 2384 (e.g., an image capture device, motion capture device, or the like) and one or more actuators may be used as the output device circuitry 2384 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 2350 may communicate over the IX 2356. The IX 2356 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 2356 may be a proprietary bus, for example, used in a SoC based system.

The number, capability, and/or capacity of the elements of system 2350 may vary, depending on whether computing system 2350 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 2350 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus, comprising:
a first amplifier coupled to a first sense node;
a second amplifier coupled to a second sense node;
one or more current mirrors coupled to at least one of the first or second amplifiers; and
a voltage output node coupled to the one or more current mirrors, wherein a voltage of the voltage output node is based on a current between the first and second sense nodes.

2. The apparatus of claim 1, further comprising:
a current path coupled to outputs of the first and second amplifiers;
wherein the one or more current mirrors comprise a first current mirror having an input coupled to the current path and a second current mirror to mirror an output current of the first current mirror to the voltage output node.

3. The apparatus of claim 1 or 2, further comprising:
a current path coupled to outputs of the first and second amplifiers; wherein:
a current path comprises a p-type transistor, a resistor, and an n-type transistor;
the p-type transistor comprises a source coupled to a power supply, a gate coupled to the output of the first amplifier, and a drain coupled to a non-inverting input of the first amplifier and to the resistor; and
the n-type transistor comprises a drain coupled to the resistor and to a non-inverting input of the second amplifier, a gate coupled to the output of the second amplifier, and a source coupled to the input of the first current mirror.

4. The apparatus of any one of claims 1-3, further comprising a current path coupled to outputs of the first and second amplifiers, wherein the current path comprises a resistor and an n-type transistor.

5. The apparatus of claim 4, wherein:
the resistor is coupled to an output of the first amplifier, to an inverting input of the first amplifier, and to a non-inverting input of the second amplifier; and
the n-type transistor comprises a drain coupled to the resistor and to a non-inverting input of the second amplifier, a gate coupled to the output of the second amplifier, and a source coupled to the input of the first current mirror.

6. The apparatus of any one of claims 1-5, further comprising a second resistor coupled between ground and the voltage output node, wherein the second resistor is programmable to adjust a gain of the one or more current mirrors.

7. The apparatus of any one of claims 1-6, further comprising a voltage divider coupled to a load, wherein the first and second sense nodes are at intermediate points of the voltage divider.

8. The apparatus of any one of claims 1-7, further comprising an additional current sensing circuit coupled to the first and second sense nodes.

9. The apparatus of any one of claims 1-8, wherein the one or more current mirrors comprise a cascoding current mirror coupled to outputs of the first and second amplifiers.

10. The apparatus of any one of claims 1-9, wherein the first amplifier comprises a first source-follower and the second amplifier comprises a second source-follower, and the one or more current mirrors comprise a first current mirror coupled to the first source-follower, a second current mirror coupled to the second source-follower, and a subtraction circuit coupled to the first and second current mirrors, wherein the subtraction circuit is to subtract a current of the second current mirror from a current of the first current mirror.

11. The apparatus of claim 10, wherein the first source-follower comprises an n-type transistor having a gate coupled to the first sense node.

12. The apparatus of claim 10 or 11, wherein the second source-follower comprises an n-type transistor having a gate coupled to the second sense node.

13. The apparatus of any one of claims 1-12, wherein the second sense node is on a die, the die is in a semiconductor package, and the first sense node is in the semiconductor package, external to the die.

14. The apparatus of claim 13, further comprising:
one or more processor cores on the die; and
a circuit coupled to the voltage output node, wherein the circuit is to detect a current of the one or more processor cores based on a voltage of the voltage output node and decide whether to throttle a frequency of the one or more processor cores based on the current.

15. The apparatus of any one of claims 1-14, further comprising a current-sensing circuit which includes the first amplifier, the second amplifier, the one or more current mirrors and the voltage output node, wherein the current-sensing circuit is provided in at least one of an integrated circuit, a System on Chip, a System in Package or a computing device.
